# EUROPÄISCHE PATENTANMELDUNG

(11) **EP 1 174 924 A2**
(43) Veröffentlichungstag der Anmeldung: **23.01.2002**
(21) Anmeldenummer: 01116329.2
(22) Anmeldetag: 05.07.2001
(51) Int. Cl.: H01L 27/115, G11C 11/15

(54) **MRAM-Speicherzelle**

(30) Priorität: 18.07.2000 DE 10034868
(71) Anmelder: Infineon Technologies AG, 81669 München (DE)
(72) Erfinder: Hoenigschmid, Heinz, East Fishkill, NY 12524 (US)
(74) Vertreter: Müller . Hoffmann & Partner Patentanwälte

(57) **Zusammenfassung**

Die Erfindung betrifft eine MRAM-Speicherzelle aus einem magnetoresistiven Widerstand (1) und einem Schalttransistor (2), bei der der magnetoresistive Widerstand (1) zwischen einer zum Wortleitungs-Stitch und auch zum Schreiben dienenden mittleren Metallisierungsebene (M1) und einer oberen Metallisierungsebene (M2) liegt. Eine Wortleitung-BOOST-Schaltung (B) ist im Stitch-Bereich jeder Zelle vorgesehen, so daß die kritische Spannung im magnetoresistiven Widerstand (1) nicht erreicht wird und dennoch der Schalttransistor (2) leitend geschaltet werden kann.

## Beschreibung

Die vorliegende Erfindung betrifft eine MRAM-Speicherzelle aus einem magnetoresistiven Widerstand und einem Schalttransistor, bei der der magnetoresistive Widerstand zwischen zwei sich im wesentlichen senkrecht kreuzenden Leiterbahnen liegt, von denen eine Leiterbahn in einer obersten Metallisierungsebene verläuft und bei der der Schalttransistor mit Source bzw. Drain, Gate und Drain bzw. Source durch Leiterbahnen in einer nullten, ersten und zweiten Metallisierungsebene kontaktiert ist, wobei Source bzw. Drain an eine in der nullten Metallisierungsebene verlaufende Bitleitung eines Speicherzellenfeldes und Gate über eine Wortleitung und einen Stitch-Kontakt an die Leiterbahn der ersten Metallisierungsebene des Speicherzellenfeldes angeschlossen sind.

MRAM-Speicherzellen werden im Idealfall ohne jegliche Schaltelemente, also als reine Widerstandsmatrix ausgeführt, in welcher die einzelnen Speicherzellen an Kreuzungsstellen zwischen Wortleitungen und Bitleitungen ausgeführt sind und dabei jeweils aus einer Schicht aus hartmagnetischem Material, einer Isolierschicht aus beispielsweise einem Tunneloxid und einem weichmagnetischen Material bestehen. Ein derart aufgebauter MRAM zeichnet sich durch eine äußerst einfache Struktur aus. Er hat aber den Nachteil, daß nicht zu vernachlässigende parasitäre Ströme in den einzelnen Speicherzellenfeldern über jeweils speziell beim Lesen nicht angesprochene Speicherzellen abfließen.

Aus diesem Grund werden derzeit für MRAMs unter anderem Strukturen vorgeschlagen, die an einen DRAM angelehnt sind und bei denen Schalt- bzw. Auswahlelemente, wie beispielsweise Transistoren und Dioden, zum Einsatz gelangen.

Fig. 4 veranschaulicht eine herkömmliche MRAM-Zelle, bei der ein magnetoresistives bzw. TMR-Element 1 zwischen zwei Metallisierungsebenen M3 und M2 angeordnet ist. Die Metallisierungsebene M2 ist mit Source bzw. Drain eines in einem Halbleiterkörper vorgesehenen MOS-Feldeffekt-Schalttransistors 2 verbunden, dessen Drain bzw. Source an eine Bitleitung BL in einer Metallisierungsebene M0 angeschlossen ist. Ein Gateleiter GC ist mit einer Wortleitung WL verbunden, wobei dies in bevorzugter Weise durch einen sogenannten Stitch-Kontakt 3 zu der Metallisierungsebene M1 geschieht. Die Metallisierungsebenen M0 bis M3 sind dabei der Reihe nach über dem Gateleiter GC angeordnet, so daß, ausgehend vom Halbleiterkörper, der Gateleiter und die Metallisierungsebenen eine Reihe GC, M0, M1, M2 und M3 bilden.

Bei einer derart aufgebauten MRAM-Speicherzelle dient die Metallisierungsebene M1 zur Widerstandsreduzierung der Wortleitung WL, die über die einzelnen Stitch-Kontakte 3 jeweils an die Leiterbahn in der Metallisierungsebene M1 angeschlossen ist. Der Gateleiter GC der Schalttransistoren 2 wird in bevorzugter Weise aus dotiertem polykristallinem Silizium ausgeführt und erstreckt sich bis zu dem Stitch-Kontakt 3.

Um in die in Fig. 4 gezeigte herkömmliche Speicherzelle zu schreiben, wird ein Strom in der Größenordnung von etwa 1 bis 2 mA in den Leiterbahnen der Metallisierungsebenen M2 und M3 benötigt. Wenn diese Ströme im magnetoresistiven Widerstand 1 ein gleichgerichtetes Magnetfeld erzeugen, so wird durch dieses Magnetfeld die Polarisierungsrichtung in der weichmagnetischen Schicht bestimmt, die dann parallel oder antiparallel zu der Polarisierungsrichtung in der hartmagnetischen Schicht sein kann. Bei antiparalleler Polarisierung liegt ein hoher Widerstandswert vor, während eine parallele Polarisierung zu einem niedrigeren Widerstandswert führt. Bei einem solchen Schreibvorgang darf die Spannung an dem magnetoresistiven Widerstand etwa 0,5 V nicht übersteigen, da sonst die Isolierschicht und mit dieser die Speicherzelle zerstört werden würde.

Zum Auslesen der Speicherzelle wird an die Leiterbahn der Metallisierungsebene M3 eine Spannung von etwa 0,5 V angelegt und über den dann leitenden Schalttransistor 2 der durch den magnetoresistiven Widerstand 1 fließende Strom gemessen, der - abhängig vom Widerstandswert und damit den Magnetisierungsrichtungen in der weichmagnetischen Schicht und in der hartmagnetischen Schicht - einen hohen oder niedrigen Wert annehmen kann. Dieses Meßergebnis wird auf der Bitleitung BL in der Metallisierungsebene M0 erhalten.

Die in Fig. 4 dargestellte herkömmliche MRAM-Speicherzelle benötigt insgesamt vier Metallisierungsebenen für die Bitleitung BL (M0), die Wortleitung und Wortleitung-Stitch (M1) und die beiden Leiterbahnen, die sich kreuzen und zwischen denen an deren Kreuzungsstelle der magnetoresistive Widerstand 1 liegt (M2 und M3).

Es ist nun Aufgabe der vorliegenden Erfindung, eine MRAM-Speicherzelle zu schaffen, die mit weniger Metallisierungsebenen auskommt und damit wesentlich einfacher als die bestehende MRAM-Speicherzelle strukturiert ist.

Diese Aufgabe wird bei einer MRAM-Speicherzelle der eingangs genannten Art erfindungsgemäß dadurch gelöst, daß die oberste Metallisierungsebene die zweite Metallisierungsebene ist und der magnetoresistive Widerstand sich zwischen den Leiterbahnen der ersten und der zweiten Metallisierungsebene erstreckt, so daß die Leiterbahn der ersten Metallisierungsebene mit dem Stitch-Kontakt der Wortleitung und dem magnetoresistiven Widerstand verbunden ist und so eine Doppelfunktion eines Wortleitung-Stitches und einer Schreibleitung für den magnetoresistiven Widerstand zu erfüllen vermag.

Die erfindungsgemäße MRAM-Speicherzelle beruht zunächst auf der Erkenntnis, daß bisher (vgl. Fig. 4) die Metallisierungsebene M2 an sich nur beim Schreiben, nicht jedoch beim Lesen des magnetoresistiven Widerstandes 1 bzw. dessen Speicherzelle genutzt wird. Um nun die nur beim Schreiben, nicht aber beim Lesen benötigte Metallisierungsebene M2 einzusparen, wird bei der erfindungsgemäßen MRAM-Speicherzelle der magnetoresistive Widerstand 1 zwischen die als obere Metallisierungsebene dienende zweite Metallisierungsebene und die erste Metallisierungsebene verlagert. Da aber in den Leiterbahnen der ersten Metallisierungsebene die Spannungen nur etwa 0,5 V erreichen dürfen, damit eine Zerstörung der Speicherzelle vermieden wird, muß beim Ansteuern des Auswahltransistors ein Pegelschieber (BOOST-Schaltung) vorgesehen werden. Dieser Pegelschieber wird in bevorzugter Weise in den jeweiligen Stitch-Bereichen angeordnet, über die die Gateleiter und Wortleitungen mit der Leiterbahn der ersten Metallisierungsebene verbunden sind.

Damit benötigt die erfindungsgemäße MRAM-Speicherzelle anstelle von vier Metallisierungsebenen nur noch drei Metallisierungsebenen, was eine wesentliche Vereinfachung darstellt. Diese Vereinfachung überwiegt bei weitem den Aufwand, der für den Pegelschieber benötigt wird.

Wesentlich an der erfindungsgemäßen MRAM-Speicherzelle ist also, daß die in der ersten Metallisierungsebene verlaufende Leiterbahn, die zum "Stitchen" der Wortleitung dient, gleichzeitig auch als Schreibleitung für den magnetoresistiven Widerstand eingesetzt wird. Der Pegelschieber, der im Stitch-Bereich vorgesehen wird, gewährleistet, daß die 0,5 V übersteigende kritische Spannung an dem magnetoresistiven Widerstand nicht erreicht wird, wobei aber dennoch die Schalttransistoren ohne weiteres leitend geschaltet werden können.

Nachfolgend wird die Erfindung anhand der Zeichnungen näher erläutert. Es zeigen:
- Fig. 1: eine schematische Darstellung eines ersten Ausführungsbeispiels der erfindungsgemäßen MRAM-Speicherzelle,
- Fig. 2: eine Draufsicht auf die Anordnung mehrerer erfindungsgemäßer MRAM-Speicherzellen und deren Metallisierungsebenen,
- Fig. 3: eine schematische Seitensicht der ersten Metallisierungsebene bei der erfindungsgemäßen MRAM-Speicherzelle und
- Fig. 4: eine schematische Darstellung einer bestehenden MRAM-Speicherzelle.

Die Fig. 4 ist bereits eingangs erläutert worden.

In den Figuren werden für einander entsprechende Bauteile jeweils die gleichen Bezugszeichen verwendet.

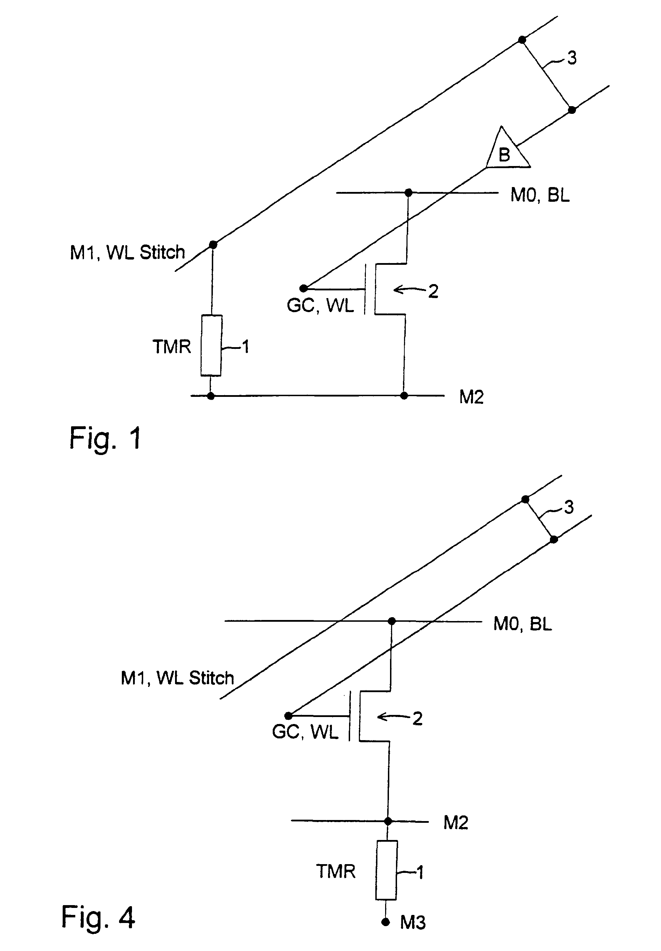

Fig. 1 zeigt einen magnetoresistiven Widerstand (TMR-Element) 1 zwischen einer Leiterbahn einer oberen Metallisierungsebene M2 und einer Leiterbahn einer mittleren Metallisierungsebene M1, die über einen Stitch-Kontakt 3 und einen Pegelschieber B mit einem Gateleiter GC eines Schalttransistors 2 verbunden ist, dessen Source-Drain-Strecke zwischen der Leiterbahn der Metallisierungsebene M2 und einer eine Bitleitung BL bildenden Leiterbahn in einer unteren Metallisierungsebene M0 liegt. Der Pegelschieber B ist von üblichem Aufbau und stellt eine BOOST-Schaltung dar. Der Gateleiter GC ist wie bei der herkömmlichen MRAM-Speicherzelle in bevorzugter Weise aus dotiertem polykristallinem Silizium hergestellt. Dieser Gateleiter GC bildet eine Wortleitung WL, die über den Stitch-Kontakt 3 mit der Leiterbahn der Metallisierungsebene M1 verbunden ist.

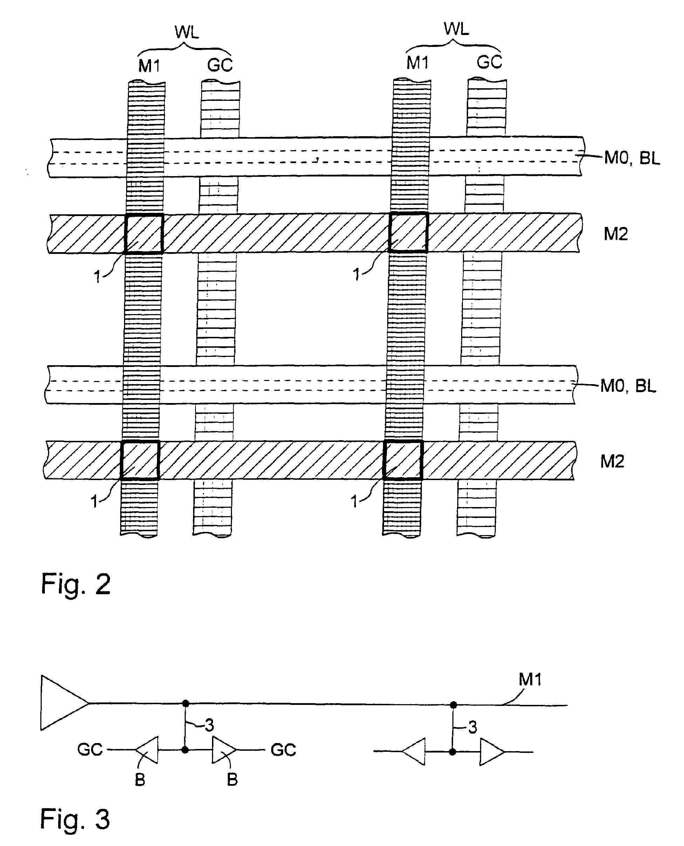

Fig. 2 zeigt in einer schematischen Draufsicht, wie die Leiterbahnen in den Metallisierungsebenen M0, M1, M2 und der Gateleiter GC zueinander geführt sein können. Wesentlich ist dabei, daß die Leiterbahnen der Metallisierungsebenen M1 und M2, an deren Kreuzungsstellen die magnetoresistiven Widerstände 1 bzw. TMR-Elemente ausgebildet sind, senkrecht zueinander verlaufen. Die Leiterbahn der Metallisierungsebene M0, welche die Bitleitung BL bildet, ist vorzugsweise in ihrem Verlauf senkrecht zu der Leiterbahn der Metallisierungsebene M1 und dem Gateleiter GC, welcher die Wortleitung darstellt, angeordnet.

Fig. 3 zeigt schematisch in einer Seitensicht die Leiterbahn der Metallisierungsebene M1, von welcher aus Stitch-Kontakte 3 senkrecht nach unten geführt und über Pegelschieber B, die im Bereich der Stitch-Kontakte 3 liegen, mit den Gateleitern GC der jeweiligen Schalttransistoren 2 verbunden sind.

Zum Schreiben wird zwischen die Leiterbahnen der Metallisierungsebenen M1 und M2 ein Strom von etwa 1 bis 2 mA eingeprägt. Die dabei anliegende Spannung sollte etwa 0,5 V nicht übersteigen, da sonst der magnetoresistive Widerstand 1 bzw. das TMR-Element zerstört werden könnte. Wie bei der herkömmlichen MRAM-Speicherzelle von Fig. 4 wird durch diesen Schreibvorgang der Widerstandswert des magnetoresistiven Widerstandes 1 festgelegt.

Bei einem Lesevorgang wird an die Leiterbahn der Metallisierungsebene M2 eine Spannung von etwa 0,5 V gelegt. Der Widerstandswert des magnetoresistiven Widerstandes 1 wird sodann über die Leiterbahn der Metallisierungsebene M1 gemessen. Da dabei der Spannungsabfall über dem magnetoresistiven Widerstand 1 0,5 V nicht überschreiten darf, muß zum Ansteuern des Schalttransistors 2 eine Spannungsverstärkung vorgenommen werden, was durch den Pegelschieber B geschieht, der zwischen dem Gateleiter GC des Schalttransistors 2 und dem Stitch-Kontakt 3 in dessen Bereich eingefügt ist. Der Pegelschieber B stellt somit sicher, daß die kritische Spannung an dem magnetoresistiven Widerstand 1 nicht erreicht wird, aber dennoch der Schalttransistor 2 leitend geschaltet werden kann.

## Patentansprüche

1. MRAM-Speicherzelle aus einem magnetoresistiven Widerstand (1) und einem Schalttransistor (2), bei der der magnetoresistive Widerstand (1) zwischen zwei sich im wesentlichen senkrecht kreuzenden Leiterbahnen liegt, von denen eine Leiterbahn in einer obersten Metallisierungsebene (M2) verläuft und bei der der Schalttransistor (2) mit Source bzw. Drain, Gate und Drain bzw. Source durch Leiterbahnen in einer nullten, ersten und zweiten Metallisierungsebene (M0, M1, M2) kontaktiert ist, wobei Source bzw. Drain an eine in der nullten Metallisierungsebene (M0) verlaufende Bitleitung (BL) eines Speicherzellenfeldes und Gate über eine Wortleitung (WL) und einen Stitch-Kontakt (3) an die Leiterbahn der ersten Metallisierungsebene (M1) des Speicherzellenfeldes angeschlossen sind,
**dadurch gekennzeichnet,**
**daß** die oberste Metallisierungsebene die zweite Metallisierungsebene (M2) ist und der magnetoresistive Widerstand (1) sich zwischen den Leiterbahnen der ersten und der zweiten Metallisierungsebene (M1, M2) erstreckt, so daß die Leiterbahn der ersten Metallisierungsebene (M1) mit dem Stitch-Kontakt (3) der Wortleitung (WL) und dem magnetoresistiven Widerstand verbunden ist und so eine Doppelfunktion eines Wortleitung-Stitches und einer Schreibleitung für den magnetoresistiven Widerstand (1) zu erfüllen vermag.

2. MRAM-Speicherzelle nach Anspruch 1,
**dadurch gekennzeichnet,**
**daß** die in der ersten Metallisierungsebene (M1) verlaufende Leiterbahn über den Stitch-Kontakt (3) mit Gateleitern (GC) von Schalttransistoren (2) verbunden ist.

3. MRAM-Speicherzelle nach Anspruch 2,
**dadurch gekennzeichnet,**
**daß** für jeden Gateleiter (GC) im Bereich des Stitch-Kontaktes (3) ein Pegelschieber (B) vorgesehen ist.

4. MRAM-Speicherzelle nach Anspruch 3,
**dadurch gekennzeichnet,**
**daß** der Pegelschieber (B) zwischen den Gateleitern (GC) und dem Stitch-Kontakt (3) vorgesehen ist.
